# EUROPEAN PATENT APPLICATION

(11) **EP 3 007 236 A1**
(43) Date of publication of application: **13.04.2016**
(21) Application number: 14807841.3
(22) Date of filing: 18.03.2014
(51) Int. Cl.: H01L 31/0749, H01L 31/04, H01L 31/18

(54) **SOLAR CELL AND METHOD FOR MANUFACTURING SAME**

(30) Priority: 05.06.2013 KR 20130064835
(71) Applicant: Jun, Young-kwon, Seoul 135-917 (KR)
(72) Inventor: Jun, Young-kwon, Seoul 135-917 (KR)
(74) Representative: Beck & Rössig European Patent Attorneys
(86) International application number: PCT/KR2014/002277
(87) International publication number: WO 2014/196728

(57) **Abstract**

Provided are a CIGS solar cell and a method for manufacturing same, wherein the CIGS solar cell comprises a substrate, a back electrode, a light-absorbing layer, a buffer layer, and a front transparent electrode, and the buffer layer includes a titanium (Ti) compound.

## Description

### TECHNICAL FIELD

The present disclosure relates to a solar cell and a method for manufacturing same.

### BACKGROUND ART

A thin film solar cell technique has received great attention as an advanced solar cell technique that is compared to a technique of crystalline silicon (Si) solar cell which currently has the largest market share.

A thin film solar cell may be manufactured at a lower cost while having a higher efficiency than a crystalline Si solar cell, wherein various types of thin film solar cells have been developed. A typical example of the thin film solar cell may be a Cu(In,Ga)Se₂ (CIGS) solar cell.

The CIGS solar cell denotes a cell that is composed of general glass substrate-back electrode-light-absorbing layer-buffer layer-front transparent electrode-antireflection coating, in which the light-absorbing layer absorbing sunlight is formed of CIGS or CuIn(S,Se)₂ (CIS). Since the CIGS is more widely used among the CIGS or the CIS, the CIGS solar cell will be described hereinafter.

Since CIGS, as a group I-III-VI chalcopyrite-based compound semiconductor (groups I, III, and IV denote groups 1B, 3B, and 6B of the Periodic Table) has a direct transition type energy bandgap and a light absorption coefficient of about 1×10⁵ cm⁻¹ which is one of the highest among semiconductors, the CIGS is a material capable of manufacturing a high-efficiency solar cell even with a 1 µm to 2 µm thick thin film.

CIGS may be used by replacing a cation, such as copper (Cu), and an anion, such as selenium (Se), respectively with other metals, and these materials may be collectively referred to as a CIGS-based compound semiconductor. The CIGS-based compound semiconductor is a material in which its energy bandgap as well as crystal lattice constant may be adjusted by changing types and compositions of constituting cations (e.g., Cu, silver (Ag), indium (In), gallium (Ga), aluminum (Al), etc.) and anions (e.g., Se and sulfur (S)).

Since the CIGS solar cell has electro-optically excellent long-term stability even at outdoors and excellent resistance to radiation, the CIGS solar cell is suitable for a spacecraft solar cell. In general, glass is used as a substrate of the CIGS solar cell, but the CIGS solar cell may be manufactured in the form of a flexible solar cell by being deposited on a polymer (e.g., polyimide) or a metal thin film (e.g., stainless steel, titanium (Ti)) substrate in addition to the glass substrate.

In particular, the CIGS solar cell, as a low-cost, high-efficiency thin film solar cell, has been known to have a very high commercialization potential which may replace a crystalline silicon solar cell, as the highest energy conversion efficiency of 19.5% among thin film solar cells has been recently realized.

In the CIGS thin film solar cell, the buffer layer is formed to a thickness of about 50 µm and plays an important role next to the light-absorbing layer. Since a CIGS thin film has an uneven surface due to polycrystalline growth morphologies, the buffer layer, in order to stabilize a device, functions to prevent device defects from being exposed by providing a conformal coverage on the surface. The buffer layer is generally formed by chemical bath deposition (CBD) of CdS and the CdS also functions to buffer a large bandgap difference between CIGS and ZnO as a transparent electrode.

Typically, CdS has been used as the buffer layer, but since cadmium is toxic, research for replacing the CdS into Zn(O, OH)S or In₂S₃ has been in progress. In particular, in a case in which ZnS is used, quantum efficiency in the ultraviolet (UV) region is higher than a case of using CdS, and thus, it is known that an additional improvement in conversion efficiency of about 8% is expected.

Also, a wet CBD preparation method has been an obstacle to a vacuum inline process. In order to overcome the obstacle, research and development of a thin film deposition method have been actively conducted in which a buffer material may be used in a vacuum process.

### DISCLOSURE OF THE INVENTION

### TECHNICAL PROBLEM

The purpose of the present invention is to provide a solar cell including a buffer layer which is harmless to the human body and has excellent chemical resistance.

The purpose of the present invention is also to provide a method for manufacturing a solar cell which may minimize the occurrence of defects in an interface and a buffer layer.

### TECHNICAL SOLUTION

According to an embodiment of the present invention, there is provided a solar cell comprising a substrate; a back electrode; a light-absorbing layer; a buffer layer; and a front transparent electrode, wherein the buffer layer includes a titanium (Ti) compound.

The buffer layer may have a thickness of 100 nm or less.

The buffer layer may be formed by an atomic layer deposition(ALD) method.

The light-absorbing layer may include a compound composed of M¹, M², M³ (where M¹ is copper (Cu), silver (Ag), or a combination thereof, M² is indium (In), gallium (Ga), aluminum (Al), zinc (Zn), tin (Sn), or a combination thereof, and M³ is selenium (Se), sulfur (S), or a combination thereof), and a combination thereof.

The Ti compound may include TiO₂, Ti(OH)₄, Ti(SH)₂, TiOS, TiS(OH)₂, or a combination thereof.

The solar cell may further comprise an antireflection coating.

According to another embodiment of the present invention, there is provided a method for manufacturing a thin film solar cell comprising a substrate; a back electrode; a light-absorbing layer; a buffer layer; and a front transparent electrode, wherein the buffer layer is formed by an atomic layer deposition method using a titanium (Ti) precursor material.

The Ti precursor material may include tetrakis (dimethylamino) titanium (TDMAT, Ti[N(CH₃)₂]₄), tetrakis (diethylamido) titanium (TDEAT, Ti[N(C₂H₅)₂]₄), tetrakis (ethylmethylamido) titanium (TEMAT, Ti [N (C₂H₅) (CH₃)]₄), tetraisopropoxide (TTIP, Ti[OCH(CH₃)₂]₄), or a combination thereof.

### ADVANTAGEOUS EFFECTS

Since a CIGS thin film solar cell according to an embodiment of the present invention includes a titanium (Ti) compound, which is harmless to the human body and has excellent chemical resistance, as a buffer layer, harmlessness, optical response characteristics, and bandgap buffering properties are improved and reliability of a thin film is excellent. Also, since a method for manufacturing a CIGS thin film solar cell according to another embodiment of the present invention forms a Ti compound-containing buffer layer by using an atomic layer deposition (ALD) method, the method may improve energy band alignment properties as well as bonding at a CIGS interface. Thus, a high efficiency effect may be expected.

### BRIEF DESCRIPTION OF THE DRAWINGS

FIG. 1 is a cross-sectional view schematically illustrating a CIGS solar cell according to an embodiment of the present invention;
FIG. 2A illustrates a crystal structure of CIS;
FIG. 2B illustrates a crystal structure of CIGS;
FIG. 3 illustrates crystal structures of TiO₂;
FIG. 4 illustrates conditions of an atomic layer deposition process performed in Example 1;
FIG. 5 illustrates conditions of an atomic layer deposition process performed in Example 2; and
FIG. 6 is a photograph illustrating a CIGS solar cell prepared in Example 2.

### BEST MODE FOR CARRYING OUT THE INVENTION

An embodiment of the present invention provides a thin film solar cell including a substrate; a back electrode; a light-absorbing layer; a buffer layer; and a front transparent electrode, wherein the buffer layer includes a titanium (Ti) compound.

The buffer layer may have a thickness of 100 nm or less and may have a thickness of 30 nm to 100 nm. In a case in which the thickness of the buffer layer is 100 nm or less, the role of the buffer layer on the absorbing layer may be performed while maintaining the transmission of light. In a case in which the thickness of the buffer layer is greater than 100 nm, it is not appropriate because transparency is reduced and the amount of light arriving at the light-absorbing layer disposed under the buffer layer is decreased.

The light-absorbing layer may include a compound composed of M¹, M², M³ (where M¹ is copper (Cu), silver (Ag), or a combination thereof, M² is indium (In), gallium (Ga), aluminum (Al), zinc (Zn), tin (Sn), or a combination thereof, and M³ is selenium (Se), sulfur (S), or a combination thereof), and a combination thereof. Specific examples of the compound used in the light-absorbing layer may be Cu(In,Ga)Se₂ (CIGS) and CuIn(S,Se)₂ (CIS).

Any substrate, such as glass, soda-lime glass (SLG), a ceramic substrate, stainless steel, a metal substrate, and a polymer substrate, may be used as the above substrate as long as it is used in the art.

The back electrode may include molybdenum (Mo). Also, the front transparent electrode may be an electrode including ZnO and indium tin oxide (ITO), and may have a double structure of a first electrode including ZnO or ITO and a second electrode including Al-doped ZnO or an Al grid. In this case, the first electrode may be disposed in a direction facing the buffer layer.

The buffer layer includes a Ti compound, wherein since the titanium compound has various different crystal structures, such as tetragonal and orthorhombic, is harmless to the human body, and has excellent chemical resistance, harmlessness, optical response characteristics, and bandgap buffering properties are improved and reliability of a thin film may be improved in comparison to CdS which is harmful to the human body. The Ti compound may include TiO₂, Ti(OH)₄, Ti(SH)₂, TiOS, TiS(OH)₂, or a combination thereof.

The buffer layer may be formed by an atomic layer deposition method.

The CIGS solar cell may further include an antireflection coating. The antireflection coating may be disposed to face the front transparent electrode. That is, the antireflection coating may be formed on the front transparent electrode. The antireflection coating may include MgF₂.

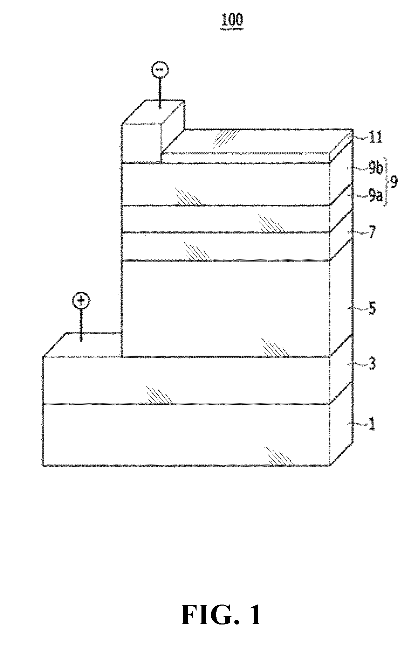

The solar cell having the above configuration according to the embodiment of the present invention is schematically illustrated in FIG. 1. The solar cell illustrated in FIG. 1 has a structure in which a front transparent electrode has a double structure of a first electrode including ZnO and a second electrode including Al-doped ZnO and an antireflection coating is included, but the solar cell of the present invention is not limited to this configuration.

As illustrated in FIG. 1, a CIGS solar cell 100 is composed of a substrate 1, a back electrode 3, a light-absorbing layer 5, a buffer layer 7, a front transparent electrode 9 (first electrode 9a and second electrode 9b), and an antireflection coating 11.

Hereinafter, a method for manufacturing a buffer layer in a method for manufacturing a CIGS solar cell according to another embodiment of the present invention will be described in detail.

In the CIGS solar cell according to the embodiment of the present invention, the buffer layer may be prepared by an atomic layer deposition method. Since the buffer layer is formed by the atomic layer deposition method, the buffer layer may be selectively grown to have a crystal phase most similar to a crystal structure of the surface of the thin film when the buffer layer is deposited on the light-absorbing layer. Thus, the occurrence of defects in an interface and the buffer layer may be minimized. Also, since the atomic layer deposition method is composed of the steps of alternating chemisorption, surface reaction, and desorption of byproducts and may deposit one atomic layer at a time, the amount of impurity may be low, defects, such as pin holes, may be minimized, and, even in a pore with a high aspect ratio, a step coverage of almost 100% may be obtained different from other chemical deposition methods or physical deposition methods.

The atomic layer deposition method may be performed by using a Ti precursor material. The Ti precursor material may include tetrakis(dimethylamino)titanium (TDMAT, Ti[N(CH₃)₂]₄), tetrakis(diethylamido)titanium (TDEAT, Ti [N (C₂H₅)₂]₄), tetrakis (ethylmethylamido) titanium (TEMAT, Ti [N (C₂H₅) (CH₃)]₄), tetraisopropoxide (TTIP, Ti [OCH(CH₃)₂]₄), or a combination thereof.

The atomic layer deposition method may be performed by being divided into 4 sections by time. The atomic layer deposition method may include a first step of adsorbing a Ti precursor material on the light-absorbing layer; a second step of removing a byproduct from the light-absorbing layer; a third step of forming a buffer layer on the light-absorbing layer by converting the Ti precursor material adsorbed on the light-absorbing layer having the byproduct removed therefrom into a Ti compound using a chemical reaction; and a fourth step of desorbing a byproduct from the buffer layer.

The chemical reaction in the third step may be an oxidation reaction.

The first step, the second step, and the fourth step may be performed in the presence of diluent gas. The diluent gas may be argon (Ar) or nitrogen (N₂). Also, hydrogen gas (H₂) may be further used with the diluent gas. In a case in which the diluent gas and the hydrogen gas are used together, a mixing ratio of the diluent gas to the hydrogen gas may be about 50 vol%:50 vol% to about 80 vol%:20 vol%. In the case that the diluent gas and the hydrogen gas are used together, the precursor material may be better reduced.

Also, the first step, the second step, and the fourth step may be performed while injecting water vapor (H₂O), H₂S gas, or a combination thereof.

In a case in which the first step, the second step, and the fourth step is performed in the presence of diluent gas (or with hydrogen gas),inca the buffer layer may include TiO₂ as the Ti compound, and in a case in which the first step, the second step, and the fourth step is performed while injecting water vapor (H₂O), H₂S gas, or a combination thereof, the buffer layer may include Ti(OH)₄, Ti(SH)₂, TiOS, TiS(OH)₂, or a combination thereof as the Ti compound.

The first step may be performed for about 0.3 seconds to about 5 seconds, the second step may be performed for about 10 seconds to about 20 seconds, the third step may be performed for about 3 seconds to about 5 seconds, and the fourth step may be performed for about 10 seconds to about 20 seconds. Also, the reaction temperature may be in a range of about 100°C to about 300°C.

In the third step, the oxidation reaction may be performed by forming plasma using gas such as oxygen, H₂O, or O₃.

The first step to the fourth step is set as 1 cycle, and the atomic layer deposition is performed to a thickness of about 100 nm or less by repeating the cycle according to deposition thickness and deposition rate. The deposition rate may be in a range of about 0.1 nm per cycle to about 0.2 nm per cycle. The atomic layer deposition thickness may be in a range of about 50 nm to about 100 nm.

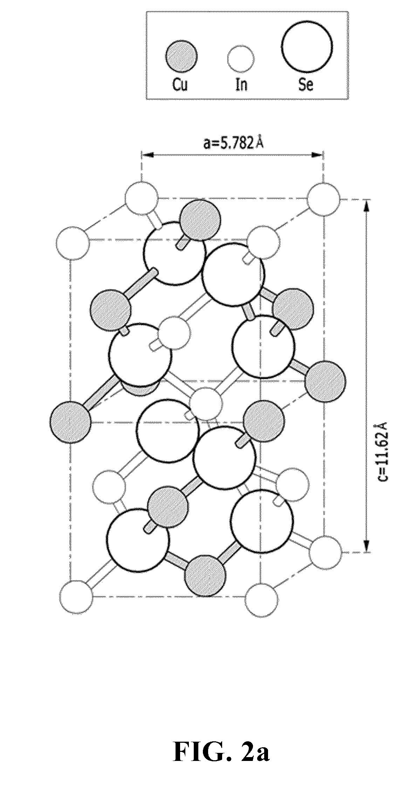

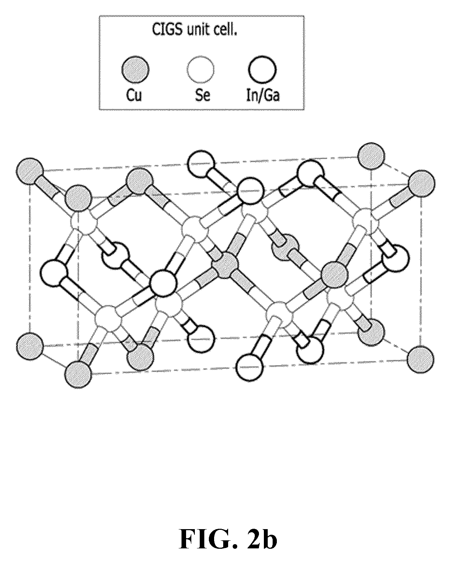

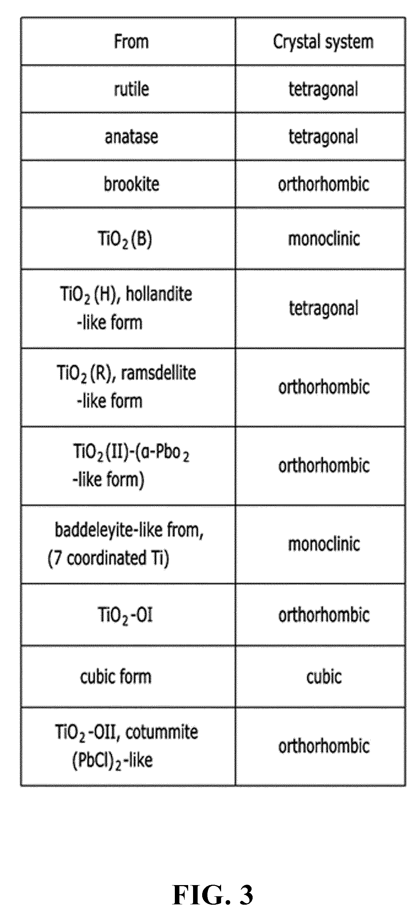

A crystal structure of CIS (CuInSe₂) is illustrated in FIG. 2A, and a crystal structure of CIGS (Cu(In, Ga)Se₂) is illustrated in FIG. 2B. As illustrated in FIGS. 2A and 2B, CIS and CIGS have a tetragonal structure, but the CIS and CIGS may have an orthorhombic structure depending on a ratio of Ga and In. Also, as illustrated in FIG. 3, TiO₂ is a material having various crystal structures.

Thus, since a buffer layer including a Ti compound is formed on the surface of the light-absorbing layer by an atomic layer deposition method, the buffer layer including the Ti compound is sequentially formed one layer by one layer on an atomic layer of the surface of the light-absorbing layer by an adsorption reaction. Thus, a thin-film layer matching the atomic arrangement of the surface of the light-absorbing layer may be formed. Also, since a thin film having a crystal structure of tetragonal or orthorhombic, which has most similar lattice size and position to the crystal structure of the surface of the material constituting the light-absorbing layer, may be grown along the surface of the light-absorbing layer, the occurrence of defects at the interface may be suppressed and physical properties of the thin film may be improved.

### MODE FOR CARRYING OUT THE INVENTION

Hereinafter, examples and comparative example of the present invention will be described. However, the following examples are merely presented to exemplify the present invention, and the present invention is not limited thereto.

### (Example 1)

A buffer layer was formed on a light-absorbing layer formed of a CIGS-based semiconductor, Cu(In, Ga)Se₂, by an atomic layer deposition process using tetrakis(dimethylamino)titanium (TDMAT) as a Ti precursor material.

The atomic layer deposition process was performed using a reactor with a scintillator precursor material inlet, a Ti precursor material inlet, and an oxygen gas inlet, and was performed in 4 steps.

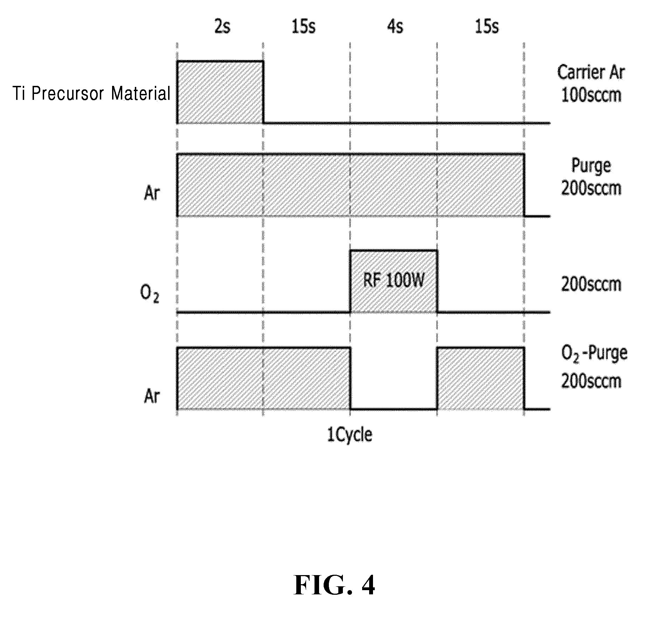

In the atomic layer deposition process, a scintillator precursor material and atmospheric conditions are illustrated in FIG. 4. In FIG. 4, 2s, 15s, 4s, and 15s in the X-axis respectively denote implementation times in a first step, a second step, a third step, and a 4^{th} step, a Ti precursor material and second Ar in the Y-axis represent materials injected into the scintillator precursor material inlet, and O₂ and fourth Ar represent materials injected into the oxygen inlet.

As the conditions illustrated in FIG. 4, Ar gas, as a diluent gas, was injected into the Ti precursor material inlet at a rate of 200 standard cubic centimeter per minute (sccm, cm³/min) from the first step to the 4^{th} step, i.e., during the entire atomic layer deposition process. Thus, the Ar gas may act as a purge gas for removing reaction gas and byproducts in the Ti precursor material inlet from the second step to the 4^{th} step.

O₂ was injected into the oxygen gas inlet in the third step, and oxygen plasma was generated by applying a radio frequency power of 100 W. In this time, the injection rate of the oxygen was 200 sccm.

Also, the Ar gas, as a diluent gas, was injected into the oxygen gas inlet at a rate of 200 sccm in the first step, the second step, and the fourth step, except for the third step, and, in this case, the Ar gas may act as a purge gas for removing reaction gas and byproducts in the oxygen gas inlet.

In the first step, tetrakis(dimethylamino)titanium (TDMAT), as a Ti precursor material, as well as Ar, as a carrier gas, was injected into the Ti precursor material inlet at a rate of 100 sccm to adsorb the Ti precursor material on a substrate at 300°C for 2 seconds.

Subsequently, a purging process for removing reaction gas and byproducts was performed at 300°C for 15 seconds (the second step). As illustrated in FIG. 4, since the Ar gas was injected during the entire process, the Ar gas may function as a diluent gas in the first step and may otherwise function as a purge gas.

Subsequently, as illustrated in FIG. 4, an oxidation reaction was performed for 4 seconds by injecting oxygen into the oxygen gas inlet at a rate of 200 sccm and generating a plasma by applying a radio frequency power of 100 W (the third step). As illustrated in FIG. 4, Ar gas was continuously injected at a rate of 200 sccm through the oxygen inlet, but, in the third step of injecting oxygen, the injection of the Ar gas was stopped and the oxidation reaction was performed. In the third step, oxygen was reacted with the previously adsorbed Ti atomic layer to form a TiO₂ reaction layer.

In the fourth step, Ar gas, as a diluent gas, was again injected at a rate of 200 sccm for 15 seconds to remove reaction gas and byproducts.

The first step to the fourth step was set as 1 cycle, and 300 cycles were performed to form an about 30 nm thick TiO₂ buffer layer on the substrate.

### (Example 2)

A soda-lime glass substrate, a Mo back electrode disposed on the substrate, and a Cu(In, Ga)Se2, as a CIGS-based semiconductor, light-absorbing layer were sequentially formed. Subsequently, a buffer layer was formed on the light-absorbing layer by an atomic layer deposition process using tetrakis(dimethylamino)titanium (TDMAT) as a Ti precursor material.

The atomic layer deposition process was performed using a reactor with a scintillator precursor material inlet, a Ti precursor material inlet, and an oxygen gas inlet, and was performed in 4 steps.

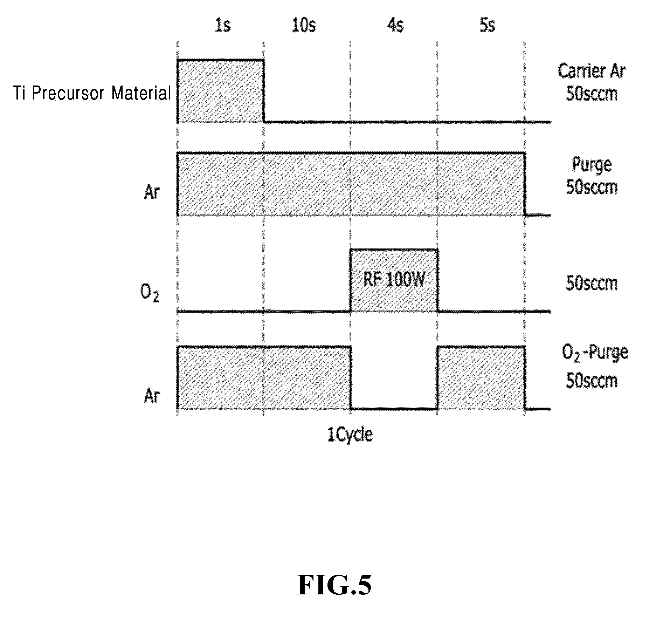

In the atomic layer deposition process, a scintillator precursor material and atmospheric conditions are illustrated in FIG. 5. In FIG. 5, 1s, 10s, 4s, and 5s in the X-axis respectively denote implementation times in a first step, a second step, a third step, and a fourth step, a Ti precursor material and second Ar in the Y-axis represent materials injected into the scintillator precursor material inlet, and O₂ and fourth Ar represent materials injected into the oxygen inlet.

As the conditions illustrated in FIG. 5, Ar gas, as a diluent gas, was injected into the Ti precursor material inlet at a rate of 50 standard cubic centimeter per minute (sccm, cm³/min) from the first step to the fourth step, i.e., during the entire atomic layer deposition process. Thus, the Ar gas may act as a purge gas for removing reaction gas and byproducts in the Ti precursor material inlet from the second step to the fourth step.

O₂ was injected into the oxygen gas inlet in the third step, and oxygen plasma was generated by applying a radio frequency power of 100 W. In this time, an injection rate was 50 sccm and the injection was performed for 4 seconds.

Also, the Ar gas, as a diluent gas, was injected into the oxygen gas inlet at a rate of 50 sccm in the first step, second step, and fourth step, except for the third step, and, in this case, the Ar gas may act as a purge gas for removing reaction gas and byproducts in the oxygen gas inlet.

In the first step, tetrakis(dimethylamino)titanium (TDMAT), as a Ti precursor material, as well as Ar, as a carrier gas, was injected into the Ti precursor material inlet at a rate of 50 sccm to adsorb the Ti precursor material on a substrate at 200°C for 1 second.

Subsequently, a purging process for removing reaction gas and byproducts was performed at 200°C for 10 seconds (the second step). Since the Ar gas was injected during the entire process, the Ar gas may function as a diluent gas in the first step and may otherwise function as a purge gas.

Subsequently, as illustrated in FIG. 5, an oxidation reaction was performed for 4 seconds by generating a plasma by applying a radio frequency power of 100 W while injecting oxygen gas into the oxygen gas inlet at a rate of 50 sccm (the third step). As illustrated in FIG. 5, Ar gas was continuously injected at a rate of 50 sccm through the oxygen inlet, but, in the third step of injecting oxygen, the injection of the Ar gas was stopped and the oxidation reaction was performed. In the third step, oxygen was reacted with the previously adsorbed Ti precursor material to form a TiO₂ reaction layer.

In the fourth step, Ar gas, as a purge gas, was again injected at a rate of 50 sccm for 5 seconds to remove reaction gas and byproducts.

The first step to the fourth step was set as 1 cycle, and 500 cycles were performed to form an about 50 nm thick TiO₂ buffer layer on the substrate.

ITO (first electrode) and Al grid (second electrode) were sequentially formed as a front transparent electrode on the buffer layer to prepare a CIGS solar cell.

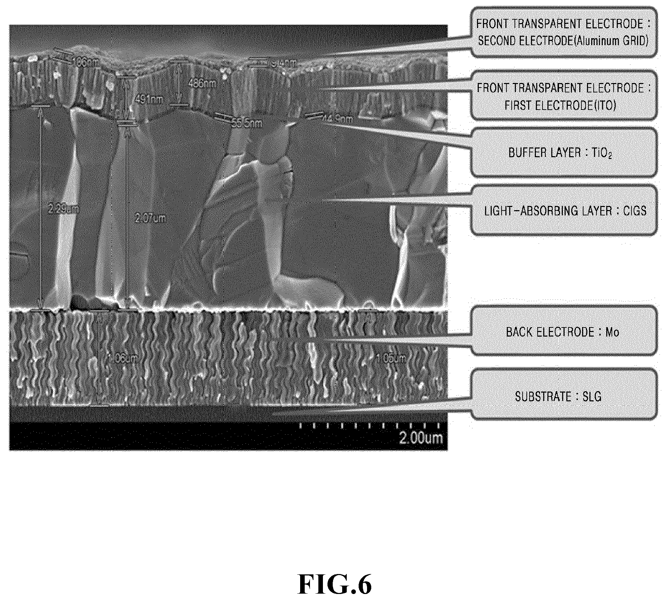

An electron microscopic image of a cross-sectional structure of the prepared solar cell is illustrated in FIG. 6.

Open-circuit voltage (V_{oc}), short-circuit current (I_{sc}), short-circuit current density (J_{sc}), fill factor (FF), and efficiency of the CIGS solar cell prepared according to Example 2 were measured, and the results thereof are presented in Table 1 below.

**[Table 1]**

| | |
|---|---|
| V_{oc} | 0.5 V |
| I_{sc} | 329.6 mA |
| J_{sc} | 52.7 mA/cm² |
| FF | 82.0% |
| Efficiency | 21.6% |

From the results shown in Table 1, since the short-circuit current (photocurrent) of the CIGS solar cell prepared according to Example 2, in which the TiO₂ buffer layer was formed, was increased in comparison to a typical solar cell (25 mA/cm² to 30 mA/cm²) and FF was higher than a typical value of 60% to 75%, it may be estimated that effective resistance was low. Also, it may be understood that the efficiency of the CIGS solar cell prepared according to Example 2 was improved in comparison to a typical efficiency value of 15% to 19%.

Although preferred embodiments of the present invention have been described above, the scope of the present invention is not limited to the embodiments. Various modifications of the embodiments may be made without departing from the spirit and scope of the invention as defined by the appended claims, and the modifications are included in the scope of the present invention.

## Claims

1. A solar cell comprising:
a substrate;
a back electrode;
a light-absorbing layer;
a buffer layer; and
a front transparent electrode,
wherein the buffer layer comprises a titanium (Ti) compound.

2. The solar cell of claim 1, wherein the buffer layer has a thickness of 100 nm or less.

3. The solar cell of claim 2, wherein the buffer layer has a thickness of 30 nm to 100 nm.

4. The solar cell of claim 1, wherein the buffer layer is formed by an atomic layer deposition method.

5. The solar cell of claim 1, wherein the light-absorbing layer comprises a compound composed of M¹, M², M³ (where M¹ is copper (Cu), silver (Ag), or a combination thereof, M² is indium (In), gallium (Ga), aluminum (Al), zinc (Zn), tin (Sn), or a combination thereof, and M³ is selenium (Se), sulfur (S), or a combination thereof), and a combination thereof.

6. The solar cell of claim 1, wherein the Ti compound comprises TiO₂, Ti(OH)₄, Ti(SH)₂, TiOS, TiS(OH)₂, or a combination thereof.

7. A method for manufacturing a solar cell comprising a substrate, a back electrode, a light-absorbing layer, a buffer layer, and a front transparent electrode,
wherein the buffer layer is formed by an atomic layer deposition method using a titanium (Ti) precursor material.

8. The method of claim 7, wherein the Ti precursor material comprises tetrakis(dimethylamino)titanium, tetrakis(diethylamido)titanium, tetrakis(ethylmethylamido)titanium, tetraisopropoxide, or a combination thereof.

9. The method of claim 7, wherein the atomic layer deposition method comprises:
a first step of adsorbing a Ti precursor material on the light-absorbing layer;
a second step of removing a byproduct from the light-absorbing layer;
a third step of forming a buffer layer on the light-absorbing layer by converting the Ti precursor material adsorbed on the light-absorbing layer having the byproduct removed therefrom into a Ti compound using a chemical reaction; and
a fourth step of desorbing a byproduct from the buffer layer.

10. The method of claim 9, wherein the chemical reaction is an oxidation reaction.
